(19) Europäisches Patentamt
European Patent Office
Office européen des brevets

(11) **EP 1 378 994 B1**

(12) **EUROPÄISCHE PATENTSCHRIFT**

(45) Veröffentlichungstag und Bekanntmachung des Hinweises auf die Patenterteilung:
**08.04.2009 Patentblatt 2009/15**

(51) Int Cl.:
***H03H 17/02*** *(2006.01)*

(21) Anmeldenummer: **03010100.0**

(22) Anmeldetag: **05.05.2003**

(54) **Verfahren zur Berechnung von Resonanzfilterkoeffizienten für digitale Resonanzfilter und digitales Resonanzfilter hierzu**

Method for calculating filter coefficients of a digital resonant filter and digital resonant filter

Méthode pour calculer les coefficients de filtrage d'un filtre résonant numérique et filtre résonant numérique

(84) Benannte Vertragsstaaten:
**DE FR GB IT**

(30) Priorität: **06.07.2002 DE 10230458**

(43) Veröffentlichungstag der Anmeldung:
**07.01.2004 Patentblatt 2004/02**

(73) Patentinhaber: **ROBERT BOSCH GMBH**
**70442 Stuttgart (DE)**

(72) Erfinder:
• **Sahrhage, Joerg**
**31139 Hildesheim (DE)**
• **Nyenhuis, Detlev**
**31079 Sibbesse (DE)**

(56) Entgegenhaltungen:
**EP-A- 0 443 115**       **US-B1- 6 405 227**

• **ARTHUR T.G. FULLER; BEHROUZ NOWROUZIAN: "Design of first- and second-order Bode-type wave-digital variable-amplitude equalizers" CANADIAN JOURNAL OF ELECTRICAL AND COMPUTER ENGINEERING, Bd. 23, Nr. 4, Oktober 1998 (1998-10), Seiten 155-162, XP009054474 Canada**
• **M.N.S. SWAMY; K.S. THYAGARAJAN: "Digital Bandpass and Bandstop Filters with Variable Center Frequency and Bandwidth" PROCEEDINGS OF THE IEEE, Bd. 64, Nr. 11, November 1976 (1976-11), Seiten 1632-1634, XP009054409**
• **PHILLIP A. REGALIA; SANJIT K. MITRA: "Tunable Digital Frequency Response Equalization Filters" IEEE TRANSACTIONS ON ACOUSTICS, SPEECH, AND SIGNAL PROCESSING, Bd. 35, Nr. 1, Januar 1987 (1987-01), Seiten 118-120, XP002346848**
• **ETTER D M ET AL: "DIRECT COMPUTATION OF SECOND-ORDER COEFFICIENTS FOR BANDPASS AND BANDSTOP DIGITAL FILTERS" SIGNAL PROCESSING, ELSEVIER SCIENCE PUBLISHERS B.V. AMSTERDAM, NL, Bd. 19, Nr. 1, Januar 1990 (1990-01), Seiten 27-41, XP000086159 ISSN: 0165-1684**

**Beschreibung**

Die Erfindung betrifft ein Verfahren zur Berechnung von Resonanzfilterkoeffizienten für digitale Resonanzfilter.

Die Erfindung betrifft weiterhin ein digitales Resonanzfilter mit Signalverarbeitungsmitteln zur Berechnung von Resonanzfilterkoeffizienten, insbesondere jedoch Wellendigital- und Direktstrukturfilter.

Resonanzfilter werden insbesondere für die Audiosignalverarbeitung, z.B. zur Entzerrung von Frequenzgängen in Verbindung mit digitalen Signalprozessoren eingesetzt. Die Resonanzfilter dienen hierbei zum Anheben bzw. Absenken einzelner Frequenzbänder im Audiosignal in definierter Weise.

Derartige digitale Resonanzfilter werden bevorzugt als digitale Wellenfilter realisiert. Bei dem Entwurf von digitalen Wellenfiltern werden die Strukturen von analogen Filtern in den digitalen Bereich übertragen. Bei der Transformation erfolgt ein Übergang von Signalflußgrößen, d. h. der Spannung U und dem Strom I, auf Wellen durch eine Linearkombination, um einen realisierbaren Filter zu erhalten, der die Realisierungsbedingung erfüllt, dass jede Rückkopplungsschleife mindestens ein Verzögerungselement enthalten muss.

Resonanzfilter in Form von Wellendigitalfiltern sind grundsätzlich beispielsweise in der DE 32 25 839 A1, DE 32 46 321 A1 und DE 44 18 164 A1 beschrieben.

Das Problem bei den herkömmlichen Resonanzfiltern in Form von Wellendigitalfiltern oder Direktstrukturfiltern ist, dass die Resonanzfilterkoeffizienten möglichst genau berechnet und zur späteren Verwendung abgespeichert werden müssen. Die Auflösung und Anzahl der verfügbaren Filtergrößen ist dabei durch die verfügbare Speicherkapazität begrenzt.

Vor allem in der Abhängigkeit von der Bandmittenfrequenz $f_0$ kommen dabei unterschiedliche Filterstrukturen zum Einsatz, für die zur Einstellung der gewünschten Frequenzgänge strukturspezifische Koeffizienten bereitzustellen sind. Insbesondere bei selbst einmessenden Entzerrfiltern, wie sie beispielsweise zur Entzerrung der Fahrzeuginnenraumakustik in Autoradios von Kraftfahrzeugen Anwendung finden, aber auch bei manuell zu bedienenden parametrischen Entzerrfiltern erfordert eine feine Abstufung der Filterkurven eine unüberschaubar große Anzahl unterschiedlicher Filterkoeffizientensätze.

Für die digitale Audiosignalverarbeitung werden insbesondere Resonanzfilter zweiter Ordnung eingesetzt, da diese sich auch auf_Festkommasignalprozessoren geringerer Wortbreite mit ausreichender Genauigkeit realisieren lassen.

In der Zeitbereichsbeschreibung ist das Resonanzfilter dadurch definiert, dass sich das Ausgangssignal $y_n$ aus einem Eingangssignal $x_n$ ergibt zu

$$y_n = -k_1 x_n + k_2(A_n + B_n)$$

mit den Zwischenwerten
$A_n = C_n + B_{n-1} + C_{n-1},$
$B_n = -\alpha(X_n + A_n) + A_n,$ und
$C_n = -\gamma(B_{n-1} + C_{n-1}) \, 2^{\gamma_{shift}} + C_{n-1},$
wobei der Index n den zeitlichen Abtastwert angibt.

Aus dem Dokument ARTHUR T.G. FULLER; BEHROUZ NOWROUZIAN: "Design of firstans second-order Bode-type wave-digital variable-amplitude equalizers" CANADIAN JOURNAL OF ELECTRICAL AND COMPUTER ENGINEERING, Bd. 23, Nr. 4, Oktober 1998 (1998-10), Seiten 155-162, XP009054474 Canada sind Design-Regeln für die Auslegung von Bode-Typ-Wellendigitalfiltern erster und zweiter Ordnung mit variabler Amplitude bekannt. Es werden dort Auslegungsregeln für die Bestimmung von Filterkoeffizienten in Abhängigkeit von unterschiedlichen Filterkenngrößen wie Bandmittenfrequenz, Güte oder einer Sprunghöhe berechnet.

Aus der EP 0 443 115 A1 geht ein Wellendigitalfilter hervor, bestehend aus Speichern und n-Tor-Adaptoren. Hierbei ist eine Übertragungsfunktion (y/x) beliebig vorgebbar. Es wird ein Filtereingangssignal über Multiplizierer individuell gewichtet und an allen Adaptor-Eingängen und Ausgängen mit Summierern eingekoppelt. Das Filterausgangssignal y wird durch Summierung der über weitere Multiplizierer gewichteten, in allen Adaptor- und Speicherein- und ausgängen ausgekoppelten Signale gebildet.

Aus der US 6,405,227 B1 ist ein Digitalfilter bekannt, bei dem eine Kreuzfilterung und eine über Parameter einstellbare Entzerrung vorgesehen ist. Ferner werden Regeln zur Bestimmung der Filterparameter angegeben.

Aufgabe der Erfindung war es, ein verbessertes Verfahren zur Berechnung von Resonanzfilterkoeffizienten für die digitale Resonanzfilter zu schaffen, um diese Resonanzfilterkoeffizienten nicht durch Speicherung, sondern durch unmittelbare Berechnung dem Resonanzfilter zur Verfügung zu stellen.

Die Aufgabe wird erfindungsgemäß durch algorithmische Berechnung der Resonanzfilterkoeffizienten in Abhängigkeit von den Filterkenngrößen Bandmittenfrequenz $f_0$, Güte Q, Anhebung g und Abtastrate $f_s$ gelöst.

Für ein oben beschriebenes Resonanzfilter zweiter Ordnung werden die Resonanzfilterkoeffizienten $k_1$, $k_2$, $\alpha$ und $\gamma$ nach den folgenden Gleichungen bestimmt:

a1) $\quad k_1 = 10^{\left(-\frac{g}{20}\right)}$ und $k_2$ = 1-$k_1$ für Anhebungen von g $\geq$ 0 oder

a2) $k_1$ = 0 und $\quad k_2 = (-1) + 10^{\left(\frac{g}{20}\right)}$ für Anhebungen von g < 0, und

b) $\quad \alpha = \dfrac{2\psi}{\psi^2 Q + \psi + Q}$ mit $\psi = \dfrac{\pi f_0}{f_s}$ und

c) $\quad \gamma = 2\sin\left(\dfrac{\pi f_0}{f_S}\right)^2$ .

Es wurde erkannt, dass diese Abhängigkeiten der Resonanzfilterkoeffizienten von den durch das Resonanzfilter zu realisierenden Filterkenngrößen eine einfache Berechnung von Resonanzfilterkoeffizienten auch mit Signalprozessoren geringer Datenwortlänge von beispielsweise 16 Bit, einer Festkommadarstellung für Daten und Koeffizienten und ohne einen Divisionsbefehl ermöglichen.

Diese Resonanzfilterkoeffizienten können insbesondere bei digitalen Wellenfiltern oder nach erneuter Umrechnung bei Direktstrukturfiltern eingesetzt werden.

Hierdurch können Filterkurven hinsichtlich der genannten Filterkenngrößen wesentlich genauer abgestuft werden, als dies unter Zuhilfenahme abgespeicherter Koeffizientensätze möglich ist.

Die Resonanzfilterkoeffizienten $k_1$ und $k_2$ legen hierbei die durch das Resonanzfilter hervorzurufende frequenzselektive Anhebung bzw. Absenkung des Eingangssignals x fest. Die Bandmittenfrequenz $f_0$ und Güte Q des Resonanzfilters wird hingegen durch die Resonanzfilterkoeffizienten $\alpha$ und $\gamma$ bestimmt.

Die Resonanzfilterkoeffizienten $k_1$ und $k_2$ sind durch die erfindungsgemäßen Berechnungsmethoden so dimensioniert, dass eine Übersteuerung bei größtmöglichem Signal-Rausch-Abstand sicher vermieden wird, indem das Resonanzfilter als ausschließlich dämpfend ausgelegt ist. Eine erforderliche Verstärkung kann dann an anderer Stelle im Signalpfad realisiert werden.

Der Resonanzfilterkoeffizient $\gamma$ kann vorzugsweise annähernd durch die Gleichung

$$\gamma = 2\left(2\rho_0 + V_3 \rho_0^3 + V_s \rho_0^5\right)^2$$

mit $V_3$=1,3284, $V_5$=0,24352 und einer normierten Frequenz und $\rho_0 = \dfrac{\psi}{2} = \dfrac{\pi f_0}{2 f_s}$ bestimmt werden. Diese Näherungsgleichung ergibt sich durch die Annahme, dass sich die Sinusfunktion zur Definition des Resonanzfilterkoeffizienten $\gamma$ im Wertebereich $-\dfrac{\pi}{2} \leq x \leq \dfrac{\pi}{2}$ als Polynom dritter Ordnung beschreiben läßt, woraus sich resultierend die Näherungsgleichung ergibt.

Für den Bereich von 2$\rho_0$< < 1 oder entsprechend der Bandmittenfrequenz $f_0 < < \dfrac{f_s}{\pi}$ kann die Näherung für die Sinusfunktion unterhalb des bestimmten Schwellwertes nach dem linearen Glied abgebrochen werden, so dass sich der Resonanzfilterkoeffizient $\gamma$ vorzugsweise annähernd zu

$$\gamma = 2\left(2\rho_0\right)^2$$

berechnet.

Für ein Resonanzfilter ist es weiterhin vorteilhaft, einen Verschiebungskoeffizienten $\gamma_{shift}$ zur Kompensation einer Hochskalierung der normierten Frequenz $\rho_0$ um eine ganzzahlige Zweierpotenz $2^n$ mit der ganzen Zahl n durch die Gleichung $\gamma_{shift}=-2n$ zu berechnen.

Die Skalierung ist von der Wortbreite des verwendeten Signalprozessors abhängig und dient zur Vermeidung, dass bei Verwendung von Festkommaarithmetik der Resonanzfilterkoeffizient $\gamma=2\,(2\rho_0)^2$ für sehr kleine Werte der normierten Frequenz $\rho_0$ verschwindet. Um dies zu vermeiden, wird die normierte Frequenz $\rho_0$ um den Verschiebungskoeffizienten $\gamma_{shift}$ hochskaliert.

Übertragungsfunktionskoeffizienten für die Übertragungsfunktion $H\,(z) = \dfrac{b_0 + b_1 z^{-1} + b_2 z^{-2}}{a_0 + a_1 z^{-1} + a_2 z^{-2}}$ des Resonanzfilters werden vorzugsweise wie folgt bestimmt:

$$a_0 \;=\; 1$$

$$a_1 \;=\; -(2-\alpha)(1-\gamma)$$

$$a_2 \;=\; 1-\alpha$$

$$b_0 \;=\; k_1 + \frac{1}{2}k_2\alpha$$

$$b_1 \;=\; -k_2\,(2-\alpha)(1-\gamma)$$

und

$$b_2 \;=\; k_1\,(1-\alpha) - \frac{1}{2}k_2\alpha.$$

Diese Übertragungsfunktionskoeffizienten lassen sich nach Normierung und Negation der Nennerkoeffizienten $a_1$ und $a_2$ unmittelbar in einem Direktstrukturfilter verwenden.

Weiterhin ist es vorteilhaft, die Güte Q durch den Faktor $10^{\frac{g}{20}}$ zu korrigieren, wenn die Absenkung g<0 ist.

Der Resonanzfilterkoeffizient $\alpha$ wird vorzugsweise zu

$$\alpha = \frac{1}{4}\,\frac{\rho_0}{\rho_0^2 q + \dfrac{1}{4}q + \dfrac{1}{8}\rho_0}$$

mit der normierten Güte $q = \dfrac{Q}{4}$ berechnen.

Das Verfahren wird vorzugsweise bei digitalen Wellenfiltern und Direktstrukturfiltern zweiter Ordnung eingesetzt.

Die Aufgabe wird weiterhin durch ein digitales Wellenfilter gelöst, das Signalverarbeitungsmittel zur Berechnung der Resonanzfilterkoeffizienten nach dem oben beschriebenen Verfahren hat.

Die Erfindung wird nachfolgend anhand der beigefügten Zeichnung näher erläutert. Es zeigt:

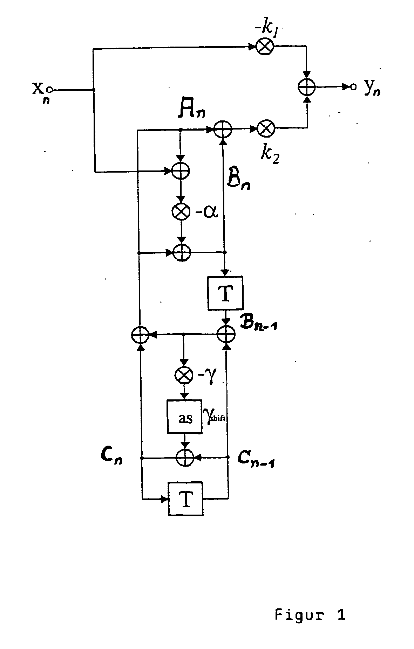

Figur 1 -    Strukturdiagramm eines Wellendigitalfilters zweiter Ordnung mit den erfindungsgemäß berechneten Resonanzfilterkoeffizienten.

Zur Realisierung eines Resonanzfilters zweiter Ordnung mit der in der Figur 1 skizzierten Wellendigitalfilterstruktur ist es erforderlich, die Resonanzfilterkoeffizienten $k_1$, $k_2$, $\alpha$, $\gamma$ und $\gamma_{shift}$ zu berechnen.

Die Berechnung dieser Resonanzfilterkoeffizienten soll anhand der Filterkenngrößen Bandmittenfrequenz $f_0$, Güte Q, Anhebung g und Abtastrate $f_s$ erfolgen, welche die Eigenschaften des zu schaffenden Resonanzfilters festlegen.

Die Wellendigitalfilterstruktur ist der Art, dass sich das Ausgangssignal $y_n$ aus dem Eingangssignal $x_n$ ergibt zu $y_n = -k_1 x_n + k_2(A_n + B_n)$, wobei die Größen $A_n$ und $B_n$ Zwischenwerte sind.

Der Zwischenwert $B_n$ wird erhalten durch

$$B_n = -\alpha(x_n + A_n) + A_n.$$

Der Zwischenwert $A_n$ wird erhalten durch

$$A_n = C_n + B_{n-1} + C_{n-1}.$$

Die Verzögerungszeit T ist von der Abtastrate $f_s$ abhängig und stellt den Kehrwert der Abtastrate $f_s$ dar T=

$$T = \frac{1}{f_s}.$$

Der Zwischenwert $C_n$ ergibt sich zu

$$C_n = -\gamma(B_{n-1} + C_{n-1})\, 2^{\gamma_{shift}} + C_{n-1}.$$

Das Wellendigitalfilter wird zur sicheren Vermeidung von Übersteuerungen bei größtmöglichem Signal-Rausch-Abstand als ausschließlich dämpfend ausgelegt. Hierzu werden die Resonanzfilterkoeffizienten $k_1$ und $k_2$ mit der Filterkenngröße Anhebung g in dB berechnet zu

$$k_1 = 10^{-\frac{g}{20}} \cdot \text{und } k_2 = 1 - k_1 \text{ für } g \geq 0 \text{ bzw.}$$

$k_1 = 1$ und $k_2 = -1 + 10^{\frac{g}{20}}$   für $g < 0$.

Aufgrund der günstigen Möglichkeiten zur Darstellung des gesamten Audio-Frequenz-Bereichs von

$$0 < f_0 < \frac{f_s}{2}$$ im Festkommaformat wird die normierte Frequenz $\rho_0 < \dfrac{\pi}{4}$ definiert als

$$\rho_0 = \frac{2\pi f_0 T}{4} = \frac{\pi f_0}{2 f_s} = \frac{\psi}{2} .$$

In gleicher Weise wird die Güte Q, die sich über ein Intervall von 0,5 bis 4 erstrecken darf, auf die normierte Güte $q = \frac{Q}{4}$ im Intervall von 0,125 bis 1 abgebildet.

Der Resonanzfilterkoeffizient wird gemäß der Formel zu

$\alpha = \frac{2\psi}{\psi^2 Q + \psi + Q}$ berechnet. Mit der Abhängigkeit $\psi = 2\rho_0$ und $Q = 4q$ berechnet sich der Resonanzfilterkoeffizient $\alpha$ zu $\alpha = \frac{1}{4} \frac{\rho_0}{\rho_0^2 q + \frac{1}{4} q + \frac{1}{8} \rho_0}$ .

Dabei kann eine Division vermieden werden, indem die Inversion des Nenners in maximal sechs Iterationen mit Hilfe des Newtonverfahrens durchgeführt wird. Durch geeignete dynamische Skalierung muß einerseits eine ausreichende Aussteuerung sichergestellt werden und andererseits einem Registerüberlauf vorgebeugt werden.

Der Resonanzfilterkoeffizient $\gamma$ hängt ausschließlich von der Abtastrate des digitalen Systems $f_s = \frac{1}{T}$ sowie von der gewünschten Bandmittenfrequenz $f_0$ des Resonanzfilters ab und berechnet sich mit

$$\varphi = \tan(\psi) = \frac{\sin(\psi)}{\cos(\psi)} \quad \text{und} \quad \psi = \left( \frac{\pi f_0}{f_s} \right) \quad \text{zu:}$$

$$\gamma = \frac{2\varphi^2}{1 + \varphi^2} = \frac{2\left( \frac{\sin(\psi)}{\cos(\psi)} \right)^2}{1 + \left( \frac{\sin(\psi)}{\cos(\psi)} \right)^2} = 2\sin(\psi)^2 = 2\sin\left( \frac{\pi f_0}{f_s} \right)^2 .$$

Die Sinusfunktion läßt sich im Wertebereich $-\frac{\pi}{2} \leq x \leq \frac{\pi}{2}$ als Polynom dritter Ordnung wie folgt beschreiben: $\sin(x) = x + a_3 x^3 + a_5 x^5 + \varepsilon(x)$ mit $|\varepsilon(x)| \leq 2 \cdot 10^{-4}$ mit $|x| \in [0, \frac{\pi}{2}]$ und $a_3 = 0,16605$ und $a_5 = 0,00761$.

Für $x = \psi = 2\rho_0$ ergibt sich für das obengenannte Polynom dritter Ordnung

$$\sin(x) = \sin(2\rho_0) = 2\rho_0 + 8a_3\rho_0^3 + 32a_5\rho_0^5 + \varepsilon(2\rho_0) = 2\rho_0 + v_3\rho_0^3 + v_5\rho_0^5 + \varepsilon(2\rho_0)$$

mit $v_3 = -1,3284$ und $v_5 = 0,24352$.

Der Resonanzfilterkoeffizient $\gamma$ läßt sich somit mit folgender Näherungsgleichung bestimmen:

$$\gamma = 2(\sin(2\rho_0))^2 \approx 2(2\rho_0 + v_3\rho_0{}^3 + v_5\rho_0{}^5)^2.$$

Im Bereich $2\rho_0 = \dfrac{\pi f_0}{f_s} << 1 \Leftrightarrow f_0 << f_s/\pi$ kann die Näherung für die Sinusfunktion unterhalb eines bestimmten Schwellwertes nach dem linearen Glied abgebrochen werden, sobald die höheren Potenzen von $\rho_0$ keinen nennenswerten Beitrag mehr zum Ergebnis liefern. Auf diese Weise vereinfacht sich die Berechnung des Resonanzfilterkoeffizienten $\gamma$ durch die Näherungsgleichung:

$$\gamma = 2(\sin(2\rho_0))^2 \approx 2(2\rho_0)^2.$$

Hierbei ergibt sich jedoch das Problem, dass bei Verwendung von Festkommaarithmetik der Term $(2\rho_0)^2$ für sehr kleine Werte von $\rho_0$ verschwindet. In diesem Fall wird die normierte Frequenz $\rho_0$ unterhalb einer bestimmten Frequenz zusätzlich um eine ganzzahlige Zweierpotenz $2^n$ mit der ganzen Zahl n hochskaliert. Diese Skalierung wird durch den Verschiebungskoeffizienten

$$\gamma_{\text{shift}} = -2n$$

kompensiert, wobei mit dem Verschiebungskoeffizienten $\gamma_{\text{shift}}$ das Ergebnis mit der Multiplikation mit $\gamma$ reskaliert wird. Die Lage der Schwellwerte für die Approximation bzw. Skalierung ist von der Wortbreite des verwendeten Signalprozessors abhängig.
Aus den Resonanzfilterkoeffizienten $k_1$, $k_2$, $\alpha$ und $\gamma$ lassen sich die Koeffizienten der Übertragungsfunktion

$$H(z) = \frac{b_0 + b_1 z^{-1} + b_2 z^{-2}}{a_0 + a_1 z^{-1} + a_2 z^{-2}}$$

wie folgt berechnen.
Die Nennerkoeffizienten ergeben sich zu

$$a_0 = 1$$

$$a_1 = -(2-\alpha)(1-\gamma)$$

$$a_2 = 1-\alpha$$

Die Zählerkoeffizienten ergeben sich zu

$$b_0 = k_1 + \frac{1}{2}k_2\alpha$$

$$b_1 = -k_2(2-\alpha)(1-\gamma),$$

und

$$b_2 = k_1(1-\alpha) - \frac{1}{2}k_2\alpha.$$

Diese Übertragungsfunktionskoeffizienten können nach einer Normierung und der Negation der Nennerkoeffizienten $a_0$, $a_1$ und $a_2$ unmittelbar in einem Direktstrukturfilter verwendet werden.

**Patentansprüche**

1. Verfahren zur Berechnung von Resonanzfilterkoeffizienten für digitale Resonanzfilter zweiter Ordnung, in denen das Ausgangssignal $y_n$ und das Eingangssignal $x_n$ im Zeitbereich durch die Gleichung

$$y_n = -k_1 x_n + k_2(A_n + B_n)$$

mit den Zwischenwerten
$A_n = C_n + B_{n-1} + C_{n-1}$,
$B_n = -\alpha(X_n + A_n) + A_n$, und
$C_n = -\gamma(B_{n-1} + C_{n-1})\, 2^{\gamma\text{shift}} + C_{n-1}$
miteinander verknüpft sind und die Zwischenwerte in Abhängigkeit von den Filterkenngrößen Bandmittenfrequenz ($f_0$), Güte (Q), Anhebung (g) und Abtastrate ($f_s$) berechnet werden, wobei $\gamma_{\text{shift}}$ ein Verschiebungskoeffizient zur Reskalierung ist, **dadurch gekennzeichnet, dass** die Resonanzfilterkoeffizienten wie folgt berechnet werden:

a1) $k_1 = 10^{\left(-\frac{g}{20}\right)}$ und $k_2 = 1 - k_1$ für Anhebungen von $g \geq 0$ oder

a2) $k_1 = 1$ und $k_2 = (-1) + 10^{\left(\frac{g}{20}\right)}$ für Anhebungen von $g < 0$, und

b) $\alpha = \dfrac{2\psi}{\psi^2 Q + \psi + Q}$ mit $\psi = \dfrac{\pi f_0}{f_s}$ und

c) $\gamma = 2\sin\left(\dfrac{\pi f_0}{f_s}\right)^2$.

2. Verfahren nach Anspruch 1, **dadurch gekennzeichnet, dass** der Resonanzfilterkoeffizient $\gamma$ annähernd durch die Gleichung

$$\gamma = 2\left(2\rho_0 + V_3 \rho_0^3 + V_5 \rho_0^5\right)^2$$

mit $V_3 = -1{,}3284$, $V_5 = 0{,}24352$ und einer normierten Frequenz

$$\rho_0 = \frac{\psi}{2} = \frac{\pi f_0}{2 f_s}$$ bestimmt wird.

3. Verfahren nach Anspruch 1, **dadurch gekennzeichnet, dass** der Resonanzfilterkoeffizient $\gamma$ annähernd zu

$$\gamma = 2(2\rho_0)^2$$

mit einer normierten Frequenz $\rho_0 = \dfrac{\psi}{2} = \dfrac{\pi f_0}{2 f_s}$

bestimmt wird, wenn die Bandmittenfrequenz ($f_0$) sehr viel kleiner als der Quotient aus Abtastrate ($f_s$) und n ist

$$H \ f_0 \ll \frac{f_s}{\pi}.$$

4. Verfahren nach einem der vorhergehenden Ansprüche, **gekennzeichnet durch** Berechnung des Verschiebungs-koeffizienten ($\gamma_{shift}$) für das digitale Resonanzfilter zur Kompensation einer Hochskalierung einer normierten Frequenz ($\rho_0$) um eine ganzzahlige Zweierpotenz ($2^n$) mit der ganzen Zahl n durch die Gleichung

$$\gamma_{shift} = -2n.$$

5. Verfahren zur Bestimmung von Übertragungsfunktionskoeffizienten für die Übertragungsfunktion

$$H(z) = \frac{b_0 + b_1 z^{-1} + b_2 z^{-2}}{a_0 + a_1 z^{-1} + a_2 z^{-2}}$$

eines Resonanzfilters aus den Resonanzfilterkoeffizienten nach einem der vorhergehenden Ansprüche zu:

$a_0 = 1$

$a_1 = (2-\alpha)(1-\gamma)$

$a_2 = 1-\alpha$

$$b_0 = k_1 + \frac{1}{2} k_2 \alpha$$

$b_1 = -k_2 (2-\alpha)(1-\gamma)$, und

$$b_2 = k_1 (1-\alpha) - \frac{1}{2} k_2 \alpha.$$

6. Verfahren nach einem der vorhergehenden Ansprüche, **gekennzeichnet durch** Korrektur der Güte (Q) **durch** den Faktor $10^{\frac{g}{20}}$, wenn die Anhebung g<0 ist.

7. Verfahren nach einem der Ansprüche 2 bis 7, **gekennzeichnet durch** Berechnen des Resonanzfilterkoeffizienten $\alpha$ zu

$$\alpha = \frac{1}{4} \frac{\rho_0}{\rho_0^2 q + \frac{1}{4}q + \frac{1}{8}\rho_0}$$

mit der normierten Güte $q = \dfrac{Q}{4}$.

8. Digitales Resonanzfilter mit Signalverarbeitungsmitteln zur Berechnung von Resonanzfilterkoeffizienten aus den Filterkenngrößen Bandmittenfrequenz ($f_0$), Güte (Q), Anhebung (g) und Abtastrate ($f_s$), wobei die Signalverarbeitungsmittel ausgebildet sind, eines der vorstehenden Verfahren auszuführen.

**Claims**

1. Method for calculating resonant filter coefficients for second-order digital resonant filters in which the output signal $y_n$ and the input signal $x_n$ are combined with one another in the time domain by means of the equation

$$y_n = -k_1 x_n + k_2 (A_n + B_n)$$

with the intermediate values
$A_n = C_n + B_{n-1} + C_{n-1}$,
$B_n = -\alpha (X_n + A_n) + A_n$, and
$C_n = -\gamma (B_{n-1} + C_{n-1})2^{\gamma \text{shift}} + C_{n-1}$
and the intermediate values are calculated on the basis of the filter characteristic variables of band mid-frequency ($f_0$), Q factor (Q), boost (g) and sampling rate ($f_S$), where $\gamma_{\text{shift}}$ is a shift coefficient for rescaling, **characterized in that** the resonant filter coefficients are calculated as follows:

a1) $k_1 = 10^{\left(-\frac{g}{20}\right)}$ and $k_2 = 1-k_1$ for boosts of $g \geq 0$ or

a2) $k_1 = 1$ and $k_2 = (-1) + 10^{\left(\frac{g}{20}\right)}$ for boosts of $g < 0$, and

b) $\alpha = \dfrac{2\psi}{\psi^2 Q + \psi + Q}$, where $\psi = \dfrac{\pi f_0}{f_s}$, and

c) $\gamma = 2\sin\left(\dfrac{\pi f_0}{f_s}\right)^2$.

2. Method according to Claim 1, **characterized in that** the resonant filter coefficient $\gamma$ is approximately determined by means of the equation

$$\gamma = 2(2\rho_0 + V_3 \rho_0^3 + V_5 \rho_0^5)^2$$

where $V_3 = -1.3284$, $V_5 = 0.24352$, and with a normalized frequency $\rho_0 \ = \ \dfrac{\psi}{2} \ = \ \dfrac{\pi f_0}{2f_s}$ .

3. Method according to Claim 1, **characterized in that** the resonant filter coefficient $\gamma$ is approximately determined as

$$\gamma \ = \ 2\,(2\rho_0)^2$$

with a normalized frequency $\rho_0 \ = \ \dfrac{\psi}{2} \ = \ \dfrac{\pi f_0}{2f_s}$ when the band mid-frequency ($f_0$) is a great deal lower than the quotient of the sampling rate ($f_s$) and $\pi\,f_0 \ll \dfrac{f_s}{\pi}$ .

4. Method according to one of the preceding claims, **characterized by** calculation of the shift coefficient ($\gamma_{shift}$) for the digital resonant filter, in order to compensate for scaling-up of a normalized frequency ($\rho_0$) by an integer power of two ($2^n$) with the integer n, by means of the equation

$$\gamma_{shift} \ = \ -2n.$$

5. Method for determining transfer function coefficients for the transfer function

$$H(z) \ = \ \frac{b_0 \ + \ b_1 z^{-1} \ + \ b_2 z^{-2}}{a_0 \ + \ a_1 z^{-1} \ + \ a_2 z^{-2}}$$

of a resonant filter from the resonant filter coefficients according to one of the preceding claims as:

$a_0 = 1$

$a_1 = -\,(2-\alpha)\,(1-\gamma)$

$a_2 = 1-\alpha$

$$b_0 \ = \ k_1 + \frac{1}{2}\,k_2\alpha$$

$b_1 = -k_2\,(2 - \alpha)\,(1-\gamma)$ , and

$$b_2 \ = \ k_1\,(1-\alpha)\,-\frac{1}{2}\,k_2\alpha.$$

6. Method according to one of the preceding claims, **characterized by** correction of the Q factor (Q) by the factor $10^{\frac{g}{20}}$ when the boost is g<0.

7. Method according to one of Claims 2 to 7,
**characterized by** calculation of the resonant filter coefficient $\alpha$ as

$$\alpha \;=\; \frac{1}{4}\;\frac{\rho_0}{\rho_0^2 q \;+\; \frac{1}{4}\; q \;+\; \frac{1}{8}\; \rho_0}$$

with the normalized Q factor $q \;=\; \dfrac{Q}{4}$.

**8.** Digital resonant filter having signal processing means for calculating resonant filter coefficients from the filter characteristic variables of band mid-frequency ($f_0$), Q factor (Q), boost (g) and sampling rate ($f_s$), the signal processing means being designed to carry out one of the above methods.

**Revendications**

**1.** Procédé de calcul de coefficients de filtre à résonance pour des filtres numériques à résonance du deuxième ordre, dans lesquels le signal de sortie $y_n$ et le signal d'entrée $x_n$ sont convolués dans le domaine temporel par l'équation :

$$y_n \;=\; -k_1 x_n \;+\; k_2 (A_n + B_n)$$

avec les valeurs intermédiaires
$A_n = C_n + B_{n-1} + C_{n-1}$,
$B_n = -\alpha(X_n + A_n) + A_n$, et
$C_n = -\gamma(B_{n-1} + C_{n-1}) 2^{\gamma_{shift}} + C_{n-1}$,
les valeurs intermédiaires étant calculées en fonction des grandeurs caractéristiques de filtres que sont la fréquence ($f_0$) au milieu de la bande, la qualité (Q), l'accentuation (g) et le taux d'échantillonnage ($f_s$), $\gamma_{shift}$ étant un coefficient de décalage utilisé pour le rééchelonnement,
**caractérisé en ce que**
les coefficients de filtre à résonance sont calculés de la façon suivante :

a1) $k_1 = 10^{\left(-\frac{g}{20}\right)}$ et $k_2 = 1 - k_1$ pour des accentuations $g \geq 0$ ou

a2) $k_1 = 1$ et $k_2 = (-1) + 10^{\left(-\frac{g}{20}\right)}$ pour des accentuations $g < 0$,

b)

$$\alpha = \frac{2\psi}{\psi^2 Q + \psi + Q}$$

avec

$$\psi = \frac{\pi f_0}{f_s}$$

et

c)

$$\gamma = 2\sin\left(\frac{\pi f_0}{f_s}\right)^2 .$$

**2.** Procédé selon la revendication 1, **caractérisé en ce que** le coefficient $\gamma$ de filtre à résonance est déterminé de manière approchée par l'équation

$$\gamma = 2\left(2\rho_0 + V_3\rho_0^3 + V_5\rho_0^5\right)^2$$

dans laquelle $V_3$ = -1,3284, $V_5$ = 0,24352 et pour la fréquence normée

$$\rho_0 = \frac{\psi}{2} = \frac{\pi f_0}{2f_s} .$$

**3.** Procédé selon la revendication 1, **caractérisé en ce que** le coefficient $\gamma$ de filtre à résonance est déterminé de manière approchée par

$$\gamma = 2(2\rho_0)^2$$

avec une fréquence normée $\rho_0$ =

$$\frac{\psi}{2} = \frac{\pi f_0}{2f_s}$$

si la fréquence ($f_0$) de milieu de bande est beaucoup plus petite que le quotient du taux d'échantillonnage ($f_s$) par $\pi$ ($f_0 \ll f_s/\pi$) .

**4.** Procédé selon l'une des revendications précédentes, **caractérisé par** le calcul des coefficients de décalage ($\gamma_{shift}$) du filtre numérique à résonance pour compenser la mise à l'échelle vers le haut d'une fréquence normée ($\rho_0$) à une puissance entière de ($2^n$), n étant un nombre entier, par l'équation :

$$\gamma_{shift} = -2n.$$

**5.** Procédé de détermination de coefficients de la fonction de transfert :

$$H(z) = (b_0 + b_1 z^{-1} + b_2 z^{-2})/(a_0 + a_1 z^{-1} + a_2 z^{-2})$$

d'un filtre à résonance à partir des coefficients de filtre à résonance selon l'une des revendications précédentes, avec :

$a_0 = 1$

$a_1 = (2-\alpha)\,(1-\gamma)$

$a_2 = 1-\alpha$

$b_0 = k_1 + 1/2 k_2 \alpha$

$b_1 = -k_2\,(2-\alpha)\,(1-\gamma)$ , et

$b_2 = k_1\,(1-\alpha) - 1/2 k_2 \alpha.$

**6.** Procédé selon l'une des revendications précédentes, **caractérisé par** la correction de la qualité (Q) par le facteur $10^{g/20}$ lorsque l'accentuation g < 0.

**7.** Procédé selon l'une des revendications 2 à 7, **caractérisé par** le calcul du coefficient $\alpha$ de filtre à résonance par

$$\alpha = \frac{1}{4}\frac{\rho_0}{\rho_0^2 q + \frac{1}{4}q + \frac{1}{8}\rho_0}$$

avec la qualité normée q = Q/4.

**8.** Filtre numérique à résonance doté de moyens de traitement du signal qui servent à calculer les coefficients de filtre à résonance à partir des grandeurs caractéristiques de filtre que sont la fréquence ($f_0$) du milieu de la bande, la qualité (Q), l'accentuation (g) et le taux d'échantillonnage ($f_s$), les moyens de traitement du signal étant configurés pour exécuter l'un des procédés ci-dessus.

Figur 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3225839 A1
- DE 3246321 A1
- DE 4418164 A1
- EP 0443115 A1
- US 6405227 B1

**In der Beschreibung aufgeführte Nicht-Patentliteratur**

- **ARTHUR T.G. FULLER ; BEHROUZ NOWROUZIAN.** Design of firstans second-order Bode-type wave-digital variable-amplitude equalizers. *CANADIAN JOURNAL OF ELECTRICAL AND COMPUTER ENGINEERING,* Oktober 1998, vol. 23 (4), 155-162